# EUROPEAN PATENT SPECIFICATION

(11) **EP 2 338 319 B1**
(45) Date of publication and mention of the grant of the patent: **11.02.2015**
(21) Application number: 09792687.7
(22) Date of filing: 18.09.2009
(51) Int. Cl.: H05K 9/00, H01L 23/552

(54) **ELECTRICALLY-CONDUCTIVE FOAM EMI SHIELD**
EMI-ABSCHIRMUNG AUS ELEKTRISCH LEITENDEM SCHAUMSTOFF
BLINDAGE EMI À MOUSSE ÉLECTROCONDUCTRICE

(30) Priority: 26.09.2008 US 100499 P
(43) Date of publication of application: 29.06.2011
(73) Proprietor: Parker-Hannifin Corporation, Cleveland, Ohio 44124-4141 (US)
(72) Inventor: BUNYAN, Michael, H., Chelmsford Massachusetts 01824 (US); WATCHKO, George, R., Stoneham Massachusetts 02180 (US); LIONETTA, William, G., Harwich Port Massachusetts 02646 (US)
(74) Representative: Belcher, Simon James
(86) International application number: PCT/US2009/057400
(87) International publication number: WO 2010/036563

(56) References cited:
- WO-A-02/071484
- WO-A-2004/027340
- WO-A-2005/064688
- DE-C1- 19 947 130

## Description

The present invention relates broadly to electromagnetic interference (EMI) shields, such as cases, housings, or parts thereof such as covers, or board-level shields such as single or multi-compartment covers or "cans," for mobile, i.e., cellular telephone handsets, telecommunication base stations, and other electronic devices, and particularly to a shield having a compartment for covering or otherwise receiving the circuitry of the device to be shielded, which compartment is provided as compression moulded into a layer of an electrically-conductive foam material.

The operation of electronic devices such as televisions, radios, computers, medical instruments, business machines, communications equipment, and the like is attended by the generation of electromagnetic radiation within the electronic circuitry of the equipment. Such radiation often develops as a field or as transients within the radio frequency band of the electromagnetic spectrum, i.e., between about 10 KHz and 10 GHz, and is termed "electromagnetic interference" or "EMI" as being known to interfere with the operation of other proximate electronic devices.

To attenuate EMI effects, shielding having the capability of absorbing and/or reflecting EMI energy may be employed both to confine the EMI energy within a source device, and to insulate that device or other "target" devices from other source devices. Such shielding is provided as a barrier which is interposed between the source and the other devices, and typically is configured as an electrically conductive and grounded housing which encloses the device, or as a "can" which covers a discrete component or componentry of the device. The housing or can may be formed of a metal such as steel, aluminium, or magnesium, or alternatively, of a plastic or other polymeric material which is filled to be electrically-conductive, or which may be provided with a conductive coating generally applied across the interior surfaces of the housing.

The coating may be an electrically-conductive paint, a conductively-filled, moulded elastomeric layer, a metal foil laminate or transfer, or a flame-sprayed or other deposited metal layer. A conductive gasket may be used to provide electrical continuity between the coating layers applied to the various mating housing parts.

Such housings, cans, and methods are further described in US-7326862, US-7005573, US-6965071, US-6809254, US-6763576, US-6521828, US-6348654 and US-5566055.

WO-A-02/071484 discloses a method of electromagnetic interference shielding electronic circuitry in an electronic device by enclosing the circuitry in a shielded compartment. The shield is provided by two foam layers. One of the foam layers is formed from a conductive material. The other is formed from a dielectric material. Openings can be cut in one of the foam layers so that the shield can be fitted over components on a circuit board.

In view of the foregoing, it may be appreciated that many different types of materials and constructions have been employed in the production of EMI shields. As may be expected, each of these materials and constructions exhibit certain inherent advantages and disadvantages.

The invention provides a method of electromagnetic interference (EMI) shielding circuitry of an electronic device, as defined in claim 1.

The EMI shields provided by the invention can be applied to cases, housings, or parts thereof such as covers, or board-level shields such as multi- or single-compartment covers or "cans" for mobile, i.e., cellular telephone handsets, telecommunication base stations, and other electronic devices.

The shield can be configured as a board-level cover or can for an electronic device, and has at least one compartment for shielding the circuitry of the device. The foam layer is provided as having a first surface and a second surface which define a thickness dimension therebetween, and an interior portion surrounded by a perimeter portion. The interior portion of the layer is hot-pressed otherwise compression moulded through the thickness dimension thereof to form a top wall portion of the shield having a compressed thickness. With the perimeter portion of the layer remaining uncompressed, the thickness dimension thereof thus extends downwardly from the top wall portion to form a side wall portion of the shield which together with the top wall portion define at least a portion of the compartment.

The underside of the top wall of the shield may be bonded or otherwise attached to a topside surface of a microprocessor or other integrated circuit (IC) chip, or other component mounted on a printed circuit board (PCB) of the circuitry of the device, such as with a layer of a pressure-sensitive adhesive or the like, and such that the side wall portion of the shield is compressed to dispose an end surface thereof on the board.

The present invention, accordingly, comprises the construction, combination of elements, and/or arrangement of parts and steps which are exemplified in the detailed disclosure to follow. Advantageously, the shield of the invention allows for a more economical construction as compared to metal stampings, while offering the designer the ability to fabricate shields having various depths and configurations. Additional advantages include a shield which is light-weight and which allows for easy peel-and-stick placement. These and other advantages will be readily apparent to those skilled in the art based upon the disclosure contained herein.

### BRIEF DESCRIPTION OF THE DRAWINGS

For a fuller understanding of the nature and objects of the invention, reference should be had to the following detailed description taken in connection with the accompanying drawings wherein:
Fig. 1 is a perspective underside view of a representative EMI shield in accordance with the present invention;
Fig. 2 is a cross-sectional perspective view of the shield of Fig. 1 taken through line 2-2 of Fig. 1, such view being rotated 180°; and
Fig. 3 is a cross-sectional of the shield of Figs. 1 and 2 as attached to the surface of an electronic component within a representative EMI shielding assembly.

The drawings will be described further in connection with the following Detailed Description of the Invention.

### DETAILED DESCRIPTION OF THE INVENTION

Certain terminology may be employed in the following description for convenience rather than for any limiting purpose. For example, the terms "forward" and "rearward," "front" and "rear," "right" and "left," "upper" and "lower," "top" and "bottom," and "right" and "left" designate directions in the drawings to which reference is made, with the terms "inward," "inner," "interior," or "inboard" and "outward," "outer," "exterior," or "outboard" referring, respectively, to directions toward and away from the center of the referenced element, the terms "radial" or "vertical" and "axial" or "horizontal" referring, respectively, to directions or planes perpendicular and parallel to the longitudinal central axis of the referenced element. Terminology of similar import other than the words specifically mentioned above likewise is to be considered as being used for purposes of convenience rather than in any limiting sense.

In the figures, elements having an alphanumeric designation may be referenced herein collectively or in the alternative, as will be apparent from context, by the numeric portion of the designation only. Further, the constituent parts of various elements in the figures may be designated with separate reference numerals which shall be understood to refer to that constituent part of the element and not the element as a whole. General references, along with references to spaces, surfaces, dimensions, and extents, may be designated with arrows or underscores.

For the illustrative purposes of the discourse to follow, the precepts of the present invention are described in connection with the construction of a single compartment foam cover or "can" which is mountable onto or over an electronic component such as a microprocessor or other IC chip for providing board-level shielding on a PCB which itself may be received within a housing, case, or other enclosure of an electronic device such as a mobile, i.e., cellular, telephone handset, or other electronics device such as a personal communications services (PCS) handset, PCMCIA card, global positioning system (GPS), radio receiver, personal digital assistant (PDA), notebook or desktop personal computer (PC), cordless telephone handset, network router or server, medical electronics device, modem, wireless communication base station, telemetry device, telematic component or system, or the like. As used herein, the term "EMI shielding" should be understood to include, and to be used interchangeably with, electromagnetic compatibility (EMC), surface grounding, corona shielding, radio frequency interference (RFI) shielding, and anti-static, i.e., electro-static discharge (ESD) protection.

It should be appreciated, however, that the shield alternatively may be configured as a multi-compartment can, or as another cover or housing of the device, or as configured for mounting to or contact with another part of the device which may be another shield, a cover or housing part, or a spacer gasket or other structure. Aspects of the present invention also may find utility in other EMI shielding applications, such as indoor or outdoor equipment cabinets. Use within those such other applications and in such other configurations therefore should be considered to be expressly within the scope of the present invention.

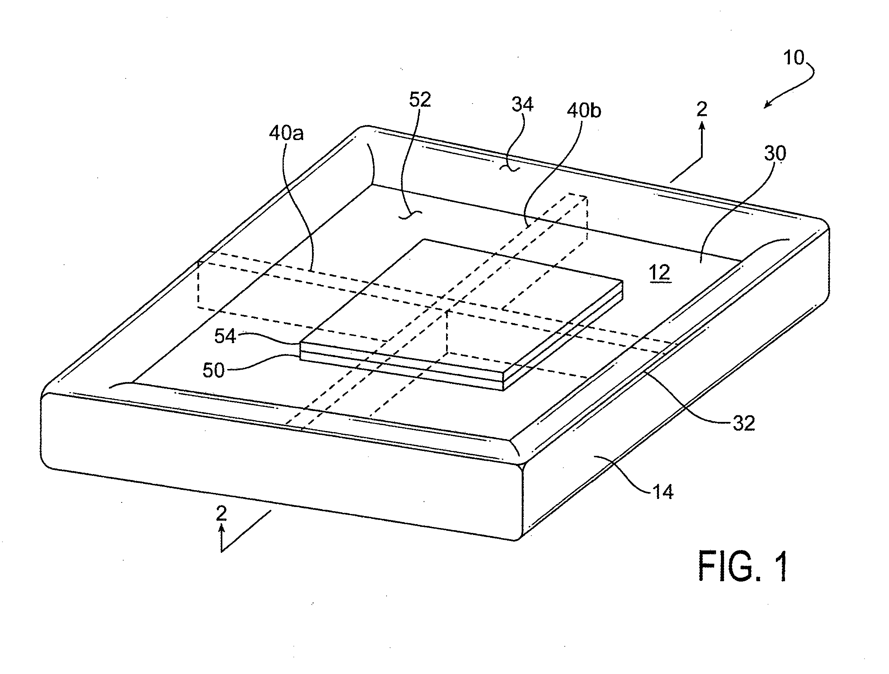

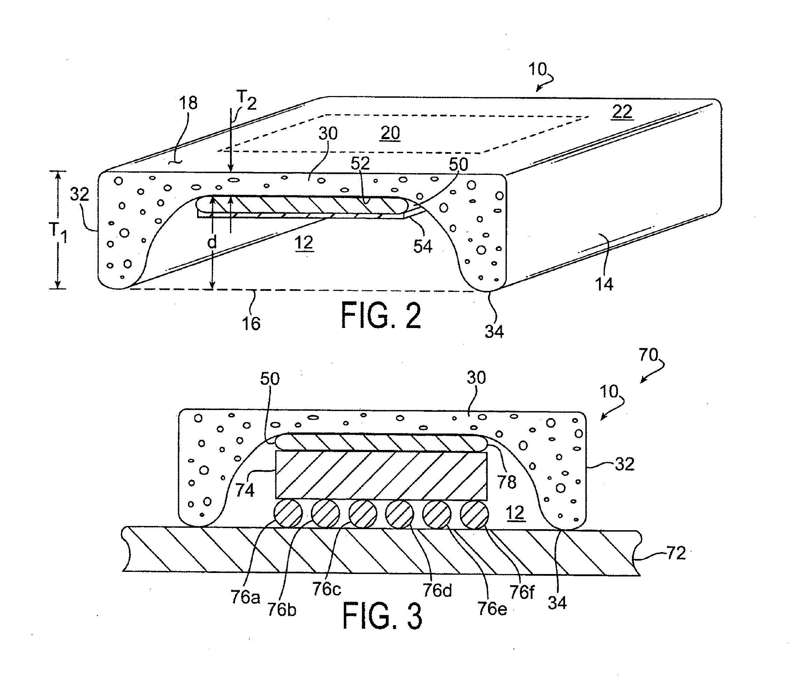

Referring then to the figures wherein corresponding reference characters are used to designate corresponding elements throughout the several views with equivalent elements being referenced with prime or sequential alphanumeric designations, an exemplary EMI shield in accordance with the present invention is shown generally at 10 in the perspective view of Fig. 1 and the cross-sectional view of Fig. 2 as having one or more compartments, one of which is referenced at 12, for enclosing the circuitry of an electronic device such as by housing separate components, circuits, or areas of the circuitry of the device for the purpose of electromagnetically isolating the same from other such components, circuits, or areas of the circuitry. In the basic construction shown, compartment 12 of shield 10 is formed from a layer, 14, of an electrically-conductive foam.

In the manufacture of shield 10, such foam layer 14 is provided as having a first surface, referenced in phantom at 16 in Fig. 1, and a second surface, 18, which together define a thickness dimension, referenced at T₁, therebetween. As sized to form the shield 10, layer 14 further has interior portion, which is the area bounded in phantom at 20, surrounded by a perimeter portion, referenced at 22. With layer 14 being so provided, interior portion of 20 thereof may be hot-pressed against or by a heated tool, or otherwise compression molded or thermoformed, through the thickness dimension T₁ to form a top wall portion, 30, of shield 10 having a compressed thickness referenced at T₂. With the perimeter portion 22 of layer 14 remaining uncompressed, the thickness dimension T₁ thereof thus extends downwardly from the top wall portion 30 to form a side wall portion, 32, of shield 10 which together with top wall portion 30 defines the compartment 14 as having a depth referenced at "d." As shown, side wall portion 32 extends from the top wall portion 30 to an end surface, 34, which may be used, for example, to contact the ground trace of a PCB. It will be appreciated that layer 14 alternatively may be formed as having internal walls, referenced in phantom at 40a-b in Fig. 1, so as to define multiple compartments 14a-d, and as having compartments 14 of different depths.

A double-sided tape or other layer, 50, of a pressure-sensitive adhesive (PSA) or other adhesive may be provided on the underside, 52, of top wall portion 30 for attaching the shield 10 to an electronic component. Such PSA or other adhesive layer may be covered by a removable release liner, referenced at 54 in Fig. 2, to allow for an easy peel-and-pick placement of the shield 10.

The electrically-conductive foam for layer 14 may be comprise a foamed polymeric material and an electrically-conductive component. The chemically, physically, or otherwise foamed polymeric material may be an open or closed-cell elastomeric thermoplastic foam or "sponge" which may be a polyethylene, polypropylene, polypropylene-EPDM blend, butadiene, styrene-butadiene, nitrile, chlorosulfonate, neoprene, urethane, silicone, or polyolefin resin/monoolefin copolymer blend, or a copolymer, blend, or other combination thereof. Such material specifically may be selected as depending upon one or more of operating temperature, compression set, force defection, flammability, compression set, or other chemical or physical properties. As used herein, the term "elastomeric" is ascribed its conventional meaning of exhibiting rubber-like properties of compliancy, resiliency or compression deflection, low compression set, flexibility, and an ability to recover after deformation.

The polymeric foam material may be rendered electrically-conductive via the incorporation of an electrically-conductive filler, web, or other component. Suitable materials for the electrically-conductive component include: noble and non-noble metals such as nickel, copper, tin, aluminum, and nickel; noble metal-plated noble or non-noble metals such as silver-plated copper, nickel, aluminum, tin, or gold; non-noble metal-plated noble and non-noble metals such as nickel-plated copper or silver; and noble or non-noble metal plated non-metals such as silver or nickel-plated graphite, glass, ceramics, plastics, elastomers, or mica; and mixtures thereof. The component may be incorporated into the foam in "particulate" form, although the particular shape of such form is not considered critical to the present invention, and may include any shape that is conventionally involved in the manufacture or formulation of conductive materials of the type herein involved including hollow or solid microspheres, elastomeric balloons, flakes, platelets, fibers, rods, irregularly-shaped particles, or a mixture thereof. Similarly, the particle size of the filler is not considered critical, and may be or a narrow or broad distribution or range, but in general will be between about 0.250-250 µm.

Alternatively, the electrically-conductive component may be incorporated into the foam material as a web such as in the manner described in U.S. Patent No. 7,022,405. Such web may be oriented or random, and may be formed of a blend of one or more conductive fibers to render the web electrically conductive, and one or more polyester, polyolefin, polyamide, or other thermoplastic polymer or co-polymer fibers which may be softenable or meltable to heat set the web. By "electrically-conductive," it is meant that the web may be rendered conductive, such as, for example, to a surface resistivity of about 0.1 Ω/sq. or less, by reason of its being constructed of electrically-conductive wire, monofilaments, yarns or other fibers or, alternatively, by reason of a treatment such as a plating or sputtering being applied to non-conductive fibers to provide an electrically-conductive layer thereon.

Preferred electrically-conductive fibers include Monel nickel-copper alloy, silver-plated copper, nickel-clad copper, Ferrex® tin-plated copper-clad steel, aluminum, tin-clad copper, phosphor bronze, carbon, graphite, and conductive polymers. Preferred non-conductive fibers include cotton, wool, silk, cellulose, polyester, polyamide, nylon, and polyimide monofilaments or yarns which are rendered electrically conductive with a metal plating of copper, nickel, silver, nickel-plated-silver, aluminum, tin, or a combination or alloy thereof. As is known, the metal plating may applied to individual fiber strands or to the surfaces of the fabric after weaving, knitting, or other fabrication.

To provide z-axis conductivity, the web may be needled, such as in the manner described in U.S. Patent No. 7,022,405, to punch strands of the fiber through the thickness dimension foam material. Thereafter, the material may be heated to soften or melt the thermoplastic fibers and thereby to fuse the web into a consolidated structure. So formed, the foam may be observed to exhibit multi-planar electrical conductivity, i.e., conductivity in the direction of the x, y, and z-axes.

The electrically-conductive component may be incorporated in the polymeric foam material in a proportion sufficient to provide the level of electrical conductivity and EMI shielding effectiveness which is desired for the intended application. For most applications, an EMI shielding effectiveness of at least 10 dB, and usually at least 20 dB, and preferably at least about 60 dB or higher, over a frequency range of from about 10 MHz to 10 GHz is considered acceptable. Such effectiveness may translate to a filler proportion which generally is between about 10-80% by volume or 50-90% by weight, based on the total volume or weight, as the case may be, of the compound, and a bulk or volume resistivity of not greater than about 1 Ω-cm, although it is known that comparable EMI shielding effectiveness may be achieved at lower conductivity levels through the use of an EMI absorptive or "lossy" filler such as a ferrite or nickel-coated graphite.

Additional fillers and additives may be included in the formulation of the foam, or the polymeric foam material thereof, as may depend upon the requirements of the particular application envisioned. Such fillers and additives, which may be functional or inert, may include wetting agents or surfactants, pigments, dispersants, dyes, and other colorants, opacifying agents, foaming or anti-foaming agents, anti-static agents, coupling agents such as titanates, chain extending oils, tackifiers, flow modifiers, pigments, lubricants such as molybdenum disulphide (MoS₂), silancs, peroxides, film-reinforcing polymers and other agents, stabilizers, emulsifiers, antioxidants, thickeners, and/or flame retardants and other fillers such as aluminium trihydrate, antimony trioxide, metal oxides and salts, intercalated graphite particles, phosphate esters, decabromodiphenyl oxide, borates, phosphates, halogenated compounds, glass, silica, which may be fumed or crystalline, silicates, mica, ceramics, and glass or polymeric microspheres.

Turning now to Fig. 3, an assembly incorporating the shield 10 of the invention is referenced generally at 70. For purposes of illustration, assembly 70 is shown to include a PCB, 72, which may be a component or module of an electronic device. An electronic component, 74, is mounted on the PCB 72, such as via one or more solder balls, 76a-f, pins, or other means of attachment. Component 74 has a topside surface, 78, opposite PCB 72.

Shield 10 may be attached to the topside surface 78 of component 74 using adhesive layer 50. As so attached, component 74 is received in compartment 12 of shield 10, with end surface 34 of side wall portion 32 contacting a ground trace (not shown) or otherwise bearing on PCB 72 to enclose the component 74. Depending on the depth d (Fig. 1) of the compartment 12, side wall portion 32 may be slightly compressed which may improve electrical contract between shield 10 and PCB 72. Shield 10 additionally may be plated, clad, or otherwise provided with a metal foil or other conductive coating to further improve such contact.

Thus, a unique EMI shield is described such as for mounting to the surface of an electronic component particularly in applications wherein weight considerations, cost, and performance are of particular concern.

## Claims

1. A method of EMI shielding electronic circuitry (74) of an electronic device (72) by enclosing the circuitry (74) within an EMI shield (10) having at least one compartment (12), the method comprising the steps of:
(a) providing a resilient layer (14) formed of a thermoformable, electrically-conductive foam, the layer (14) having first surface (16) and a second surface (18) defining a thickness dimension (T) therebetween, and the layer (14) having an interior portion (20) surrounded by a perimeter portion (22);
(b) hot-pressing the interior portion (20) of the layer (14) against or by a heated tool through the thickness dimension (T) of the layer (14) to form a top wall portion (30) of the shield (10) having a compressed thickness (T₂), the thickness dimension (T) of the perimeter portion (22) of the layer (14) remaining uncompressed and extending downwardly from the top wall portion (30) to form a side wall portion (32) of the shield (10) which together with the top wall portion (30) defines at least a portion of the compartment (12); and
(c) receiving the compartment (12) of the shield (10) over the circuitry (74) of the device (72).

2. The method of claim 1 wherein the foam comprises a foamed polymeric material and an electrically-conductive component.

3. The method of claim 2 wherein the electrically-conductive component comprises electrically-conductive fibres.

4. The method of claim 3 wherein the electrically-conductive fibres are non-conductive fibres having an electrically-conductive coating, metal wires, carbon fibres, graphite fibres, inherently-conductive polymer fibres, or a combination thereof.

5. The method of claim 4 wherein:
the non-conductive fibres are cotton, wool, silk, cellulose, polyester, polyamide, nylon, polyimide, or a combination thereof, and the electrically-conductive coating is copper, nickel, silver, aluminium, tin, carbon, graphite, or an alloy or combination thereof; and
the metal wires are copper, nickel, silver, aluminium, bronze, steel, tin, or an alloy or combination thereof, or one or more of copper, nickel, silver, aluminium, bronze, steel, tin, or an alloy or combination thereof coated with one or more of copper, nickel, silver, aluminium, bronze, steel, tin, or an alloy or combination thereof.

6. The method of claim 2 wherein the foamed polymeric material is selected from the group consisting of polyethylenes, polypropylenes, polypropylene-EPDM blends, butadienes, styrene-butadienes, nitrates, chlorosulphonates, neoprenes, urethanes, silicones, polyolefin resin/monoolefin copolymer blends, and copolymers, blends, and combinations thereof.

7. The method of claim I wherein:
the device (72) comprises a board (72) and the circuitry (74) comprises at least one component (74) mounted on the board (72), the component (74) having a topside surface (78) opposite the board (72); and
the top wall portion (30) of the shield (10) has an underside (52) bonded in step (c) to the topside surface (78) of the component (74).

8. The method of claim 7 wherein the top wall portion (30) of the shield (10) is bonded to the topside surface (78) of the component (74) with a layer (50) of an adhesive material.

9. The method of claim 7 wherein the side wall portion (32) of the shield (10) extends from the top wall portion (30) to an end surface (34), the end surface (34) being disposed in step (c) on the board (72) compressing the side wall portion (32).

## Patentansprüche

1. Ein Verfahren zur EMI Abschirmung eines elektronischen Schaltkreises (74) eines elektronischen Geräts (72) durch Einschließen des Schaltkreises (74) in einer EMI Abschirmung (10), die mindestens ein Fach (12) hat, wobei das Verfahren die Schritte umfasst:
(a) Bereitstellen einer nachgiebigen Schicht (14), die aus einem thermoformbaren elektrisch leitfähigen Schaum geformt ist, wobei die Schicht (14) eine erste Fläche (16) und eine zweite Fläche (18) hat, die eine Dickendimension (T) dazwischen definiert, und wobei die Schicht (14) einen inneren Abschnitt (20) hat, der von einem Umfangsabschnitt (22) umgeben ist;
(b) Warmpressen des inneren Abschnitts (20) der Schicht (14) gegen oder durch ein erhitztes Werkzeug durch die Dickendimension (T) der Schicht (14), um einen oberen Wandabschnitt (30) der Abschirmung (10) zu formen, der eine komprimierte Dicke (T2) hat, wobei die Dickendimension des Umfangsabschnitts (22) der Schicht (14) unkomprimiert bleibt und sich von dem oberen Wandabschnitt (30) nach unten erstreckt, um einen seitlichen Wandabschnitt (32) der Abschirmung (10) zu bilden, welches zusammen mit dem oberen Wandabschnitt (30) mindestens ein Teil des Fachs (12) definiert; und
(c) Aufnehmen des Fachs (12) der Abschirmung (10) über dem Schaltkreis (74) des Geräts (72).

2. Das Verfahren nach Anspruch 1, wobei der Schaum einen geschäumten Polymerwerkstoff und eine elektrisch leitfähige Komponente umfasst.

3. Das Verfahren nach Anspruch 2, wobei die elektrisch leitfähige Komponente elektrisch leitfähige Fasern umfasst.

4. Das Verfahren nach Anspruch 3, wobei die elektrisch leitfähigen Fasern nicht leitfähige Fasern mit elektrisch leitfähiger Beschichtung, Metalldrähte, Kohlenstofffasern, Graphitfasern, eigenleitfähige Polymerfasern oder eine Kombination daraus sind.

5. Das Verfahren nach Anspruch 4, wobei:
die nicht leitfähigen Fasern Baumwolle, Wolle, Seide, Zellulose, Polyester, Polyamid, Nylon, Polyimid oder eine Kombination daraus sind und die elektrisch leitfähige Beschichtung Kupfer, Nickel, Silber, Aluminium, Blei, Kohlenstoff, Graphit oder eine Legierung oder Kombination daraus ist; und
die Metalldrähte Kupfer, Nickel, Silber, Aluminium, Bronze, Stahl, Blei oder eine Legierung oder Kombination daraus sind, oder eines oder mehrere von Kupfer, Nickel, Silber, Aluminium, Bronze, Stahl, Blei oder eine Legierung oder Kombination daraus, beschichtet mit einem oder mehreren von Kupfer, Nickel, Silber, Aluminium, Bronze, Stahl, Blei oder einer Legierung oder Kombination daraus.

6. Das Verfahren nach Anspruch 2, wobei der geschäumte Polymerwerkstoff aus der Gruppe bestehend aus Polyethylene, Polypropylene, Polypropylene-EPDM Mischungen, Butadiene, Nitrilie, Chlorosulfonate, Neoprene, Urethane, Silikone, Polyolefinharz/Monoolefin Copolymermischungen, und Copolymere, Mischungen und Kombinationen daraus ausgewählt ist.

7. Das Verfahren nach Anspruch 1, wobei:
das Gerät (72) eine Platine (72) umfasst und der Schaltkreis (74) mindestens eine Komponente (74) umfasst, die auf der Platine (72) angebracht ist, wobei die Komponente (74) eine oberseitige Oberfläche (78) gegenüber der Platine (72) hat; und
der obere Wandabschnitt (30) der Abschirmung (10) eine Unterseite (52) hat, die in Schritt (c) an die oberseitige Oberfläche (78) der Komponente (74) angebunden wird.

8. Das Verfahren nach Anspruch 7, wobei der obere Wandabschnitt (30) der Abschirmung (10) mit der oberseitigen Oberfläche (78) der Komponente (74) über eine Schicht (50) aus einem adhäsiven Material verbunden wird.

9. Das Verfahren nach Anspruch 7, wobei der seitliche Wandabschnitt (32) der Abschirmung (10) sich von dem oberen Wandabschnitt (30) bis zu einer Endfläche (34) erstreckt, wobei die Endfläche (34), die in Schritt (c) auf der Platine (72) angeordnet wird, den seitlichen Wandabschnitt (32) komprimiert.

## Revendications

1. Procédé de blindage contre les interférences électromagnétiques (EMI) de circuits électroniques (74) d'un dispositif électronique (72) en enfermant le circuit (74) à l'intérieur d'un blindage EMI (10) ayant au moins un compartiment (12), le procédé comprenant les étapes qui consistent :
(a) à fournir une couche élastique (14) formée d'une mousse électroconductrice thermoformable, la couche (14) présentant une première surface (16) et une deuxième surface (18) définissant entre elles une dimension d'épaisseur (T), et la couche (14) présentant une partie interne (20) entourée d'une partie de périmètre (22) ;
(b) à presser à chaud la partie interne (20) de la couche (14) contre ou par un outil chauffé à travers la dimension d'épaisseur (T) de la couche (14) pour former une partie de paroi supérieure (30) du blindage (10) ayant une épaisseur comprimée (T₂), la dimension d'épaisseur (T) de la partie de périmètre (22) de la couche (14) restant non comprimée et s'étendant vers le bas à partir de la partie de paroi supérieure (30) pour former une partie de paroi latérale (32) du blindage (10) qui conjointement avec la partie de paroi supérieure (30) définit au moins une partie du compartiment (12) ; et
(c) à recevoir le compartiment (12) du blindage (10) sur les circuits (74) du dispositif (72).

2. Procédé de la revendication 1, dans lequel la mousse comprend un matériau polymère en mousse et un composant électroconducteur.

3. Procédé de la revendication 2, dans lequel le composant électroconducteur comprend des fibres électroconductrices.

4. Procédé de la revendication 3, dans lequel les fibres électroconductrices sont des fibres non conductrices ayant un revêtement électroconducteur, des fils métalliques, des fibres de carbone, des fibres de graphite, des fibres de polymère intrinsèquement conductrices, ou une combinaison de ceux-ci.

5. Procédé de la revendication 4, dans lequel :
les fibres non conductrices sont du coton, de la laine, de la soie, de la cellulose, du polyester, du polyamide, du nylon, du polyimide, ou une combinaison de ceux-ci, et le revêtement électroconducteur est du cuivre, du nickel, de l'argent, de l'aluminium, de l'étain, du carbone, du graphite, ou un alliage ou une combinaison de ceux-ci ; et
les fils métalliques sont du cuivre, du nickel, de l'argent, de l'aluminium, du bronze, de l'acier, de l'étain, ou un alliage ou une combinaison de ceux-ci, ou un ou plusieurs élément(s) parmi le cuivre, le nickel, l'argent, l'aluminium, le bronze, l'acier, l'étain, ou un alliage ou une combinaison de ceux-ci, revêtu(s) d'un ou de plusieurs élément(s) parmi le cuivre, le nickel, l'argent, l'aluminium, le bronze, l'acier, l'étain, ou un alliage ou une combinaison de ceux-ci.

6. Procédé de la revendication 2, dans lequel le matériau polymère en mousse est choisi dans le groupe constitué de polyéthylènes, de polypropylènes, de mélanges polypropylène-EPDM, de butadiènes, de butadiènes-styrène, de nitrites, de chlorosulfonates, de néoprènes, d'uréthanes, de silicones, de mélanges résine de polyoléfine/copolymère de monooléfine, et de copolymères, de mélanges et de combinaisons de ceux-ci.

7. Procédé de la revendication 1, dans lequel :
le dispositif (72) comprend une carte (72) et les circuits (74) comprennent au moins un composant (74) monté sur la carte (72), le composant (74) présentant une surface supérieure (78) opposée à la carte (72) ; et
la partie de paroi supérieure (30) du blindage (10) présente une face inférieure (52) liée dans l'étape (c) à la surface supérieure (78) du composant (74).

8. Procédé de la revendication 7, dans lequel la partie de paroi supérieure (30) du blindage (10) est liée à la surface supérieure (78) du composant (74) avec une couche (50) d'un matériau adhésif.

9. Procédé de la revendication 7, dans lequel la partie de paroi latérale (32) du blindage (10) s'étend à partir de la partie de paroi supérieure (30) vers une surface d'extrémité (34), la surface d'extrémité (34) étant disposée dans l'étape (c) sur la carte (72) comprimant la partie de paroi latérale (32).
